(19) Europäisches Patentamt
European Patent Office
Office européen des brevets

(11) **EP 3 346 336 A1**

(12) **EUROPÄISCHE PATENTANMELDUNG**

(43) Veröffentlichungstag:
**11.07.2018   Patentblatt 2018/28**

(51) Int Cl.:
*G03F 7/20* (2006.01)   *G02B 27/44* (2006.01)
*G01B 11/24* (2006.01)   *G03F 1/38* (2012.01)
*G03F 1/44* (2012.01)   *G02B 5/18* (2006.01)
*G03F 9/00* (2006.01)   *H01L 21/266* (2006.01)

(21) Anmeldenummer: 17207075.7

(22) Anmeldetag: **13.12.2017**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**MA MD TN**

(30) Priorität: **09.01.2017   DE 102017100273**

(71) Anmelder: **Bundesrepublik Deutschland, vertr.
durch das
Bundesministerium f. Wirtschaft und
Technologie,
38116 Braunschweig (DE)**

(72) Erfinder:
• **SOLTWISCH, Victor
12437 Nuthetal (DE)**
• **PFLÜGER, Mika
10827 Berlin (DE)**

(74) Vertreter: **Lins, Martina
Gramm, Lins & Partner
Patent- und Rechtsanwälte PartGmbB
Theodor-Heuss-Strasse 1
38122 Braunschweig (DE)**

(54) **VERFAHREN ZUR QUALITÄTSSICHERUNG EINER BELICHTUNGSMASKE UND BELICHTUNGSMASKE**

(57)    Die Erfindung betrifft ein Verfahren zur Qualitätssicherung einer mikroelektronischen Nutzstruktur (14) mit den Schritten (a) Aufbringen einer Kalibrierstruktur (12) und der Nutzstruktur (14) auf ein Substrat (10), wobei die Nutzstruktur (14) eine Vorzugsrichtung (V) aufweist und wobei sich die Kalibrierstruktur (12) in eine Erstreckungsrichtung (E) erstreckt und periodisch aufgebaut ist, (b) Vermessen der Kalibrierstruktur (12) mittels monochromatischer Strahlung und (c) Bestimmen einer Abweichung der Kalibrierstruktur (12) von einer Soll-Kalibrierstruktur, welches sich dadurch auszeichnet, dass (d) die Erstreckungsrichtung (E) einen Azimutalwinkel ($\varphi$) mit der Vorzugsrichtung (V) bildet, sodass beim Vermessen der Kalibrierstruktur (12) in einer Beugungsordnung (n), die von null verschieden ist, Reflexionsstrahlungsanteile von der Nutzstruktur (14) und von der Kalibrierstruktur (12) separiert sind.

Fig. 1a

EP 3 346 336 A1

A - A

Fig. 1b

**Beschreibung**

Die Erfindung betrifft ein Verfahren zur Qualitätssicherung einer mikroelektronischen Nutzstruktur, insbesondere auf einer Belichtungsmaske oder auf einem Wafer, gemäß dem Oberbegriff von Anspruch 1.

Gemäß einem zweiten Aspekt betrifft die Erfindung ein Substrat mit einer mikroelektronischen Nutzstruktur, insbesondere eine Belichtungsmaske zur Herstellung von Halbleiter-Bauelementen oder einem Wafer, gemäß dem Oberbegriff von Anspruch 9.

Belichtungsmasken werden bei der Herstellung von Halbleiterbauelementen wie integrierte Schaltungen verwendet. Diese Belichtungsmasken werden zwischen einer Lichtquelle und einem zu belichtenden Wafer positioniert und sorgen dafür, dass manche Bereiche des Wafers abgedunkelt und andere Bereiche belichtet werden.

Um mehr Schaltkreise pro Flächeneinheit auf einem Wafer unterbringen zu können, wird die Strukturbreite der zu ätzenden Nutzstruktur immer weiter verringert. Besonders kleine Strukturweiten sind mit der bestehenden Technologie, die auf Lithographie bei 192 Nanometer beruht, kaum noch weiter zu reduzieren.

Es ist daher wahrscheinlich, dass in Zukunft EUV (englisch: extreme ultra vio-let)-Lithographie zum Einsatz kommen wird. Zwar bringt diese deutlich geringere Wellenlänge technologisch deutliche Vorteile, problematisch ist aber die starke Absorption dieser Strahlung durch fast alle Materialien. Es ist daher notwendig, bei den lithographischen Verfahren statt in Transmissions-Anordnung in ReflexionsAnordnung zu arbeiten. Das betrifft alle optischen Elemente, die bei dem Lithographie-Verfahren verwendet werden, insbesondere die Belichtungsmasken. Bei den Belichtungsmasken handelt es sich daher vorzugsweise um Vielschichtsysteme, die eine Vielzahl, insbesondere zumindest 30, an Schichten aufweisen. Insbesondere weist die Belichtungsmaske alternierende Schichten aus Molybdän und Silizium auf. Derartige Belichtungsmasken werden als Bragg-Reflektoren bezeichnet. Sie können so aufgebaut werden, dass sie bei 13,5 Nanometern eine hohe Reflektivität aufweisen, was bevorzugt ist.

Zur Kontrolle, ob die Nutzstruktur, insbesondere auf einem Substrat wie einer Belichtungsmaske, die geforderte Genauigkeit hat, werden Kalibrierstrukturen aufgebracht, die auch als metrologische Messfelder bezeichnet werden. Diese Kalibrierstrukturen sind beispielsweise Gitterstrukturen und können aus einer Vielzahl parallel zueinander verlaufender Nuten bestehen. Die zwischen den Nuten verbliebenen Stege haben eine Breite, die zumindest im Wesentlichen der Strukturbreite der Nutzstruktur entspricht.

Zur Qualitätskontrolle der Nutzstruktur wird angenommen, dass die Nutzstruktur genau dann den Qualitätsanforderungen genügt, wenn die Kalibrierstruktur den Qualitätsanforderungen genügt.

Diese anvisierten Strukturverkleinerungen stellen die klassischen metrologischen Messmethoden vor Herausforderungen. Die Wellenlänge der Strahlung, mit der die Kalibrierstruktur untersucht wird, stellt einen wichtigen begrenzenden Faktor dar. Um kleinere Struktureinheiten aufzulösen, muss Strahlung einer kurzen Wellenlänge verwendet werden.

Es ist möglich, in einer Transmissionsanordnung zu messen. In diesem Fall durchdringt die Strahlung die zu vermessende Probe. Nachteilig daran ist, dass die Dicke der Belichtungsmasse nach oben begrenzt ist. Auch können sehr komplexe Strukturen nicht vermessen werden. Der Hintergrund ist, dass das eingestrahlte Licht, insbesondere Röntgenlicht, die Probe durchdringen muss und damit nicht vollständig absorbiert werden darf. Zum anderen muss sichergestellt sein, dass nur die zu vermessenden Kalibrierstrukturen und/oder Lichtstrukturen mit der Strahlung wechselwirken.

Es ist zudem möglich, wie in dem Aufsatz "Determination of line profiles on nano-structured surfaces using EUV and X-ray scattering" von Soltwisch et al., in: Proceedings of SPIE, Vol. 9235, 2014 Photomask Technology 2014, S 92351D-1 bis 92351D-9 beschrieben, in Reflexionsanordnung zu messen. Der Einfallswinkel kann so klein sein, dass Totalreflexion eintritt. Nachteilig bei derartigen Messaufbauten ist jedoch, dass der Messstrahl auch bei kleinem Strahldurchmesser kaum auf die Kalibrierstruktur, also das metrologische Messfeld, eingeschränkt werden kann. Das führt entweder zu schwer interpretierbaren Streumessergebnissen oder zur Notwendigkeit, große metrologische Messfelder vorzusehen, was unerwünscht ist, da das die Fläche verringert, die für die Nutzstruktur zur Verfügung steht.

Der Erfindung liegt die Aufgabe zugrunde, die Qualitätssicherung für Belichtungsmasken zu verbessern.

Die Erfindung löst das Problem durch ein Verfahren mit den Merkmalen von Anspruch 1. Gemäß einem zweiten Aspekt löst die Erfindung das Problem durch ein Substrat mit den Merkmalen von Anspruch 1.

Vorteilhaft an der Erfindung ist, dass der Strahl, mit dem die Kalibrierstruktur vermessen wird, in seiner Breite nicht stark eingeschränkt werden muss. So ist es unschädlich, wenn nicht nur die Kalibrierstruktur sondern auch die Nutzstruktur bestrahlt wird. Dennoch ergeben sich gut auswertbare Messergebnisse.

Es ist ein weiterer Vorteil, dass die Präparation der Belichtungsmaske mit dem gleichen Verfahren wie bisher durchgeführt werden kann. Wird beispielsweise, wie gemäß einer bevorzugten Ausführungsform vorgesehen, die Nutzstruktur mit einem Elektronenstrahl oder einem Ionenstrahl in die entstehende Belichtungsmaske geätzt, so kann mit dem gleichen Strahl wie bisher auch die Kalibrierstruktur geschrieben werden. Ein besonderer Vorteil ist, dass es entbehrlich ist, die Ätztiefe lokal inkrementell einzustellen. Es ist ausreichend, dass die Ätztiefe auf dem gesamten Substrat in guter Näherung gleich ist.

Im Rahmen der vorliegenden Beschreibung wird unter der Kalibrierstruktur insbesondere eine Struktur verstanden, die nicht Bestandteil eines elektronischen Schaltelementes ist oder - bei der Verwendung der Belichtungsmaske zum Herstellen eines Halbleiterbauteils - nicht zu einem elektronischen Schaltelement führt und zur Beurteilung der Qualität der Belichtungsmaske dient.

Günstig ist es, wenn die Kalibrierstruktur periodisch ist. Beispielsweise besteht die Kalibrierstruktur aus parallel zueinander angeordneten, vorzugsweise äquidistanten, Gräben.

Unter der Nutzstruktur wird insbesondere strukturiertes Material verstanden, das beim Einsatz zum Schalten elektrischer Ströme oder Spannungen dient oder das - bei der Verwendung der Belichtungsmaske in einem Herstellungsverfahren für Halbleiterbauteile - dazu führt, dass eine Nutzstruktur auf dem Wafer entsteht.

Unter dem Vermessen der Kalibrierstruktur mittels monochromatischer Strahlung wird insbesondere verstanden, dass zumindest die Kalibrierstruktur mit monochromatischer Strahlung beleuchtet und die gestreute und/oder transmittierte Strahlung erfasst wird.

Unter monochromatischer Strahlung wird eine Strahlung verstanden, die eine solche spektrale Leistungsdichte aufweist, dass sie im Rahmen des gewählten Versuchsaufbaus in guter Näherung als aus nur einer Wellenlänge bestehend genähert werden kann. Selbstverständlich existiert monochromatische Strahlung im idealen Sinne nicht. So besitzt die spektrale Leistungsdichte zwar ein Maximum, es existieren aber auch Wellenlängen, die von der Wellenlänge des Maximums abweichen. Es ist zudem möglich, dass die Strahlung weitere Wellenlängen enthält, die sich zwar deutlich von der Wellenlänge des Maximums unterscheiden, die aber entweder so schwach sind, dass sie vernachlässigt werden können, oder aber sich so stark von der Wellenlänge des Maximums unterscheiden, dass sie bei der Auswertung herausgerechnet werden können. Beispielsweise kann die monochromatische Strahlung auch Harmonische der Wellenlänge des Maximums der spektralen Leistungsdichte enthalten.

Unter dem Bestimmen der Abweichung einer Kalibrierstruktur von einer Soll-Kalibrierstruktur wird insbesondere verstanden, dass aus den Messergebnissen, die beim Vermessen der Kalibrierstruktur erhalten werden, auf eine Abweichung zwischen der tatsächlichen Kalibrierstruktur, die auch als Ist-Kalibrierstruktur bezeichnet werden kann, und einer vorgegebenen Soll-Kalibrierstruktur geschlossen wird. Es ist dabei möglich, nicht aber notwendig, dass die Kalibrierstruktur aus den Messdaten rekonstruiert wird. Ein solches Verfahren ist beispielsweise in dem Artikel von Marlowe et al. "Modeling and empirical characterization of the polarization response of offplane reflection grating", Applied optics, Vol. 55 Nr. 21, S. 5548 - 5553, dem Artikel von Soltwisch et al., "Determination of line profiles on nano-structured surfaces using EUV and X-ray scattering", Proc. of SPIE Vol. 9235, 92351 D-1 bis D-9, oder dem Artikel von Suh et al., "Characterization of the shape and line-edge roughness of polymer grating with grazing incidence small-angle X-ray scattering and atomic force microscopy", J. Appl. Chryst. (2016), 49, oder in dem Artikel von Wernecke et al., "Direct structural characterization of line gratings with grazing incidence small-angle x-ray scattering", REVIEW OF SCIENTIFIC INSTRUMENTS 83, 102906 (2012), beschrieben.

Es ist vielmehr auch möglich, dass die Abweichung zwischen dem Messergebnis, das durch Bestrahlen der realen Kalibrierstruktur erhalten wurde, und dem Messergebnis, das beim Bestrahlen der Soll-Kalibrierstruktur zu erhalten wäre, bestimmt wird. Beispielsweise wird die auf den Mittelwert aller Helligkeitswerte normierte Summe aller Quadrate von pixelweise gemessenen Helligkeitswerten berechnet und als Maß für die Abweichung verwendet. Wie genau die Abweichung der Kalibrierstruktur von der Soll-Kalibrierstruktur bestimmt wird, ist für die Erfindung irrelevant. Maßgeblich ist, dass eine technisch sinnvolle Aussage darüber getroffen wird, ob die Kalibrierstruktur auf der Belichtungsmaske der Soll-Kalibrierstruktur hinreichend gut entspricht oder nicht.

Unter dem Merkmal, dass die Nutzstruktur eine Vorzugsrichtung aufweist wird insbesondere verstanden, dass eine Raumrichtung existiert, entlang derer sich die Bestandteile der Nutzstruktur erstrecken. In aller Regel existieren zwei Vorzugsrichtungen, die senkrecht zueinander verlaufen. Mikroelektronische Nutzstrukturen besitzen nämlich in der Regel Leiterbahnen, die allesamt in die Vorzugsrichtung oder senkrecht dazu ausgerichtet sind, um möglichst platzsparend angeordnet werden zu können. Die Vorzugsrichtung bezieht sich dabei auf eine Richtung in der Ebene einer Oberfläche des Wafers, nicht aber in Tiefenrichtung.

Da in der Regel zwei Vorzugsrichtungen existieren, bilden bereits existierende Nutzstrukturen einen Winkel von 0° oder 90° mit der Nutzstruktur. Existieren zwei Vorzugsrichtungen, wird für die Bestimmung des Azimutalwinkels stets die Richtung gewählt, für die sich der betragsmäßig kleinste Azimutalwinkel ergibt. Der Azimutalwinkel wird dabei stets als nicht negativ betrachtet.

Unter der Erstreckungsrichtung wird insbesondere eine solche Richtung verstanden, in der die Kalibrierstruktur gleiche Querschnitte hat. Besteht die Kalibrierstruktur beispielsweise - was eine bevorzugte Ausführungsform darstellt - aus parallel zueinander verlaufenden Stegen, die durch Nuten getrennt sind, so entspricht die Erstreckungsrichtung der Längsrichtung der Stege der Nuten.

Das Vermessen der Kalibrierstruktur mittels monochromatischer Strahlung umfasst insbesondere ein Bestrahlen der Kalibrierstruktur mit der monochromatischen Strahlung. Als Strahlungsquelle wird beispielsweise ein Laser, ein Synchrotron oder eine Röntgenquelle verwendet, beispielsweise eine Röntgenröhre mit oder ohne Drehanode, eine Flüssigmetallstrahlröhre oder eine Laser-Plasma-Röntgenquelle.

Unter dem Merkmal, dass die Kalibrierstruktur periodisch aufgebaut ist, wird insbesondere verstanden, dass die Kalibrierstruktur beschrieben werden kann als Wiederholung einer Grundstruktur. In anderen Worten lässt sich die Kalibrierstruktur insbesondere beschreiben durch eine Funktion, die eine Periode hat. Die kleinstmögliche Periode ist die Strukturbreite.

Unter dem Merkmal, dass der Azimutalwinkel so groß ist, dass die Reflexionsstrahlungsanteile von der Nutzstruktur und von der Kalibrierstruktur separiert sind, wird insbesondere verstanden, das die Maxima gleicher Beugungsordnung einerseits der Kalibrierstruktur und anderseits der Nutzstruktur zumindest 0,05° voneinander getrennt sind.

Besonders bevorzugt ist die periodische Struktur eines Gitters. Allgemein bei periodischen Strukturen und speziell bei Gittern wird einfallend elektromagnetische Strahlung hauptsächlich nicht diffus in den ganzen Raum gestreut, sondern stark gerichtet in Reflexe, die sich bei definierten Raumwinkeln befinden. Speziell bei Gittern oder anderen periodischen Strukturen, wie zum Beispiel Zylindern auf einem quadratischen Gitter, ergibt sich, wenn die Kalibrierstruktur in Reflexionsanordnung mittels der monochromatischen Strahlung vermessen wird, eine Reihe von Reflexionen verschiedener Beugungsordnungen.

Die direkte Reflexion wird als nullte Ordnung bezeichnet. Die Position der höheren Nummern, also von null verschiedenen Ordnungen, hängt vom Einfallswinkel $\alpha_i$, von der Wellenlänge $\lambda$ der einfallenden monochromatischen Strahlung, von der Ordnungszahl n, von der Strukturbreite p, insbesondere vom Abstand der Gitterlinien (Englisch: pitch) p sowie vom Azimutalwinkel $\varphi$ zwischen der Projektion des einfallenden Strahls auf die Probenebene und der Kalibrierstruktur ab. Es ergibt sich für den Ausfallswinkel $\alpha_f$, der zwischen der Ebene gemessen wird, entlang der sich Nutzstruktur und die Kalibrierstruktur erstrecken, einerseits und dem reflektierten Strahl andererseits, die folgende Formel:

$$\alpha_f = \arcsin\left(\sqrt{sin^2\alpha_i - \left(\frac{n\lambda}{p}\right)^2 - \frac{2n\lambda}{p}\sin\varphi\cos\alpha_i}\right)$$

Für den azimutalen Ausfallwinkel $\theta_f$, der in der Ebene gemessen wird, in der sich die Nutzstruktur erstreckt, ergibt sich:

$$\theta_f = \arcsin\left(\frac{cos\varphi n\lambda}{pcosa_f}\right)$$

Auch kleine Abweichungen im Azimutalwinkel $\varphi$ führen daher zu großen Abweichungen in der Position der Beugungsanordnung, wenn $n \neq 0$ gilt. Besonders große Abweichungen ergeben sich im Ausfallswinkel $\alpha_f$.

Werden zwei Strukturen mit hinreichender Periodizität, im vorliegenden Fall die Nutzstruktur und die Kalibrierstruktur, mit monochromatischer Strahlung beleuchtet und existiert ein Azimutalwinkel $\varphi$ zwischen der Erstreckungsrichtung und der Vorzugsrichtung, so sind die Streureflexe auch bei gleichzeitiger Beleuchtung von Nutzstruktur und Kalibrierstruktur voneinander getrennt.

Der Erfindung liegt die Erkenntnis zugrunde, dass die Nutzstrukturen, beispielsweise auf Belichtungsmasken oder auch einem Wafer, als in recht guter Näherung periodisch betrachtet werden können. Da die Kalibrierstruktur ebenfalls periodisch ausgebildet ist, zwischen der Erstreckungsrichtung der Kalibrierstruktur und der Vorzugsrichtung der Nutzstruktur jedoch der Azimutalwinkel, der von 0 verschieden ist, existiert, können die Reflexionen von Nutzstruktur und Kalibrierstruktur voneinander getrennt werden.

Gemäß einer bevorzugten Ausführungsform erfolgt das Vermessen der Kalibrierstruktur in Reflexionsanordnung und in einer Beugungsordnung, die zumindest n > 1, insbesondere zumindest n = 4, vorzugsweise zumindest n = 5 beträgt. Den oben angegebenen Formeln ist zu entnehmen, dass dann die Reflexe der Kalibrierstruktur besonders gut von den Reflexen der Nutzstruktur getrennt werden können.

Vorzugsweise beträgt der Azimutalwinkel $\varphi$ zumindest 0,1°, insbesondere zumindest 0,2°. Alternativ oder zusätzlich beträgt der Azimutalwinkel vorzugsweise höchstens 20°, insbesondere höchstens 5°.

Insbesondere umfasst das erfindungsgemäße Verfahren den Schritt eines Markierens der Belichtungsmaske als anforderungskonform, wenn die Abweichung der tatsächlichen Kalibrierstruktur von der Soll-Kalibrierstruktur hinreichend klein ist, insbesondere wenn ein die Abweichung beschreibender Abweichungsparameter unterhalb eines vorgegebenen Schwellenwerts liegt.

Vorzugsweise umfasst das Vermessen der Kalibrierstruktur den Schritt des Bestrahlens der Kalibrierstruktur mit einem Strahl monochromatischer Strahlung und eines Aufnehmens von reflektierter Strahlung mittels eines Detektors. Vorzugsweise wird ein 2D-Photonenzähldetektor verwendet.

Günstig ist es, wenn die Kalibrierstruktur eine Gitterstruktur ist. In diesem Fall fällt der Strahl an elektromagnetischer Strahlung vorzugsweise zumindest im Wesentlichen parallel zu den Gitterlinien ein. Unter dem Merkmal, dass der Strahl zumindest im Wesentlichen parallel zu den Gitterlinien einfällt, wird insbesondere verstanden, dass ein Winkel zwischen einer Erstreckungsrichtung der Gitterlinien und einer Projektion des einfallenden Strahls auf die Kalibrierstruktur-Ebene höchstens 0,01° beträgt.

Das Bestrahlen erfolgt vorzugsweise im Vakuum, insbesondere bei höchstens 1 hPa. Günstig ist es, wenn der Strahl unter streifendem Einfall auf die Kalibrierstruktur trifft. Vorzugsweise beträgt ein Einfallswinkel $\alpha_i$ höchstens 5°, insbesondere höchstens 3°.

Vorzugsweise werden die Kalibrierstrukturen und die Nutzstrukturen mittels des gleichen Schreibers, insbesondere eines Elektronenstrahlschreibers, hergestellt. Elektronenstrahlschreiber (englisch: electron beam writer) werden dazu verwendet, Belichtungsmasken zu strukturieren. Dadurch, dass die Kalibrierstruktur und die Nutzstruktur mittels des gleichen Schreibers hergestellt werden, ist sichergestellt, dass von einer fehlerfreien Kalibrierstruktur auf eine fehlerfreie Nutzstruktur geschlossen werden kann.

Günstig ist es, wenn eine Strukturbreite der Kalibrierstruktur und/oder der Nutzstruktur höchstens 60 Nanometer, insbesondere höchstens 20 Nanometer, beträgt. Bei solch kleinen Strukturbreiten ist eine präzise Vermessung mit herkömmlichen Verfahren nicht möglich.

Vorzugsweise entspricht die Strukturbreite der Kalibrierstruktur einer Strukturbreite der Nutzstruktur. Die Strukturbreite p kann auch als Strukturkonstante (englisch: pitch) bezeichnet werden. Die Strukturbreite ist der kleinste Abstand, um den die Kalibrierstruktur senkrecht zur Erstreckungsrichtung verschoben werden kann, sodass die Kalibrierstruktur auf sich selbst abgebildet wird. Unter dem Merkmal, dass die Strukturbreite der Kalibrierstruktur einer Strukturbreite der Nutzstruktur entspricht, wird insbesondere verstanden, dass die beiden um höchstens 50% voneinander abweichen. In anderen Worten ist ein Quotient aus dem kleineren der beiden Werte und dem größeren der kleinen Werte zumindest 0,5.

Vorzugsweise wird eine Strahlung verwendet, bei der das Maximum der spektralen Leistungsdichte bei höchstens 20 Nanometer, vorzugsweise höchstens 15 Nanometer, liegt. Vorzugsweise liegt das Minimum der spektralen Leistungsdichte der Strahlung bei zumindest 0,04 Nanometer, vorzugsweise zumindest 1,5 Nanometer.

Vorzugsweise werden ein Einfallswinkel $\alpha_i$, unter dem die monochromatische Strahlung auf die Kalibrierstruktur fällt, die Beugungsordnung n, in der die reflektierte Strahlung gemessen wird, die Vakuum-Wellenlänge $\lambda$ der monochromatischen Strahlung und der Azimutalwinkel $\varphi$ so gewählt werden, dass für eine azimutalwinkelbedingte Höhen-Ausfallswinkeldifferenz $\Delta\alpha_f$ gilt:

$$\Delta\alpha_f = \left|\alpha_{f,12} - \alpha_{f,14}\right| = \left|\arcsin\left(\sqrt{\sin^2\alpha_i - \left(\frac{n\lambda}{p_{12}}\right)^2} - \sin\varphi\cos\alpha_i\frac{n\lambda}{p_{12}}\right) - \right.$$

$$\left.\arcsin\left(\sqrt{\sin^2\alpha_i - \left(\frac{n\lambda}{p_{14}}\right)^2}\right)\right| \geq 0{,}05°,$$

wobei $p_{12}$ die Strukturbreite der Kalibrierstruktur und $p_{14}$ eine Strukturbreite der Nutzstruktur ist. Alternativ oder zusätzlich werden die genannten Größen so gewählt, dass für eine azimutalwinkelbedingte Ebenen-Ausfallswinkeldifferenz $\Delta\theta_f$ gilt:

$$\Delta\theta_f = \left|\theta_{f,12} - \theta_{f,14}\right| = \left|\arcsin\left(\frac{n\lambda}{p_{12}}\frac{\cos\varphi}{\cos\alpha_{f_{12}}}\right) - \arcsin\left(\frac{n\lambda}{p_{14}\cos\alpha_{f_{14}}}\right)\right| \geq 0{,}05°.$$

Dadurch wird sichergestellt, dass die Winkelabweichung zwischen einem Reflex, der von der Nutzstruktur hervorgerufen wurde, und einem Reflex, der von der Kalibrierstruktur hervorgerufen wurde, hinreichend groß ist, um mit hoher Genauigkeit aufgelöst zu werden.

Vorzugsweise wird das Vermessen der Kalibrierstruktur mittels monochromatischer Strahlung zwischen zwei Lithographie-Schritten durchgeführt. Unter einem Lithographie-Schritt wird ein Verfahrensabschnitt verstanden, bei dem eine Maske aufgebracht, ausgehärtet und selektiv abgetragen wird, wobei danach bei aufgebrachter Maske ein Teil des Wafers abgeätzt wird und danach die Richtungsmaske entfernt wird.

Erfindungsgemäß ist zudem ein Verfahren zum Herstellen eines Halbleiterbauteils, bei dem zum Belichten eine erfindungsgemäße Belichtungsmaske verwendet wird.

Im Folgenden wird die Erfindung anhand der beigefügten Zeichnungen näher erläutert. Dabei zeigt

Figur 1    mit den Teilfiguren 1a und 1b eine erfindungsgemäße Belichtungsmaske zum Durchführen eines erfindungsgemäßen Verfahrens und

Figur 2     eine schematische Ansicht eines Versuchsaufbaus zum Vermessen der Kalibrierstruktur mittels monochromatischer Strahlung.

Figur 3a    zeigt den Versuchsaufbau gemäß Figur 2 in einer anderen Ansicht und

Figur 3b    zeigt einen Schnitt durch die Ewald-Kugel für die Reflexe der Kalibrierstruktur und der Nutzstruktur.

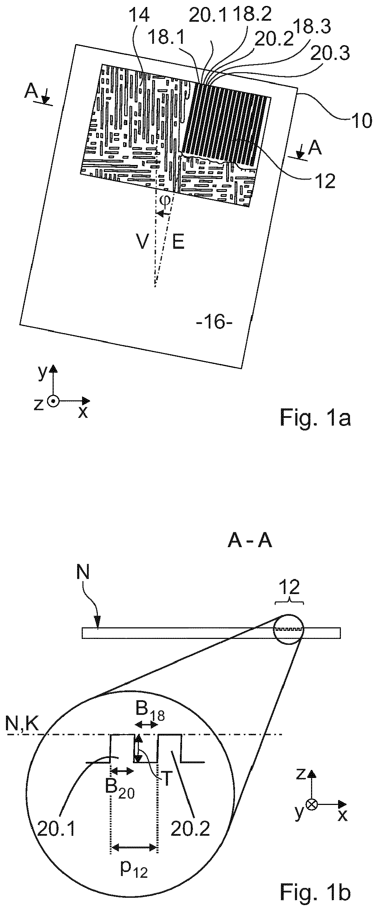

Figur 1 zeigt eine erfindungsgemäße Belichtungsmaske 10, die eine Kalibrierstruktur 12 und eine Nutzstruktur 14 aufweist. Die Kalibrierstruktur 12 und die Nutzstruktur 14 sind in jeweiligen Bereichen eines Substrats 16 ausgebildet, wobei die beiden Bereiche disjunkt sind. In anderen Worten ist an keiner Stelle der Oberfläche des Substrats 16 sowohl die Kalibrierstruktur 12 als auch die Nutzstruktur 14 aufgebracht.

In Figur 1a sind beide Strukturen 12, 14 schematisch eingezeichnet. Die Nutzstruktur 14 ist beispielsweise so ausgebildet, dass die Belichtungsmaske 10 im Rahmen eines Verfahrens zum Herstellen eines Halbleiterbauteils zum Belichten eines mit Fotolack beschichteten Wafers verwendet werden kann.

Die Kalibrierstruktur 12, die wie die Nutzstruktur 14 in Figur 1a deutlich vergrößert dargestellt ist, ist gebildet durch parallel zueinander verlaufende Nuten 18.1, 18.2, .... Die Nuten haben eine Breite Bis (vgl. Figur 1b) von beispielsweise 15 Nanometer. Zwischen zwei benachbarten Nuten verläuft ein Steg 20.1, 20.2, ..., wobei jeder Steg eine Breite $B_{20}$ von im vorliegenden Fall 16 Nanometer hat. Eine Strukturbreite $p_{12}$ der Kalibrierstruktur 12 beträgt damit $p_{12}$ = $B_{18}$ + $B_{20}$.

Die Nuten 18.i (i = 1, 2, 3, ...) haben eine Tiefe T von beispielsweise 20 Nanometer.

Das Substrat 16 besteht beispielsweise aus Silizium. Die Strukturen 12, 14 werden beispielsweise durch elektronenstrahlinduziertes Ätzen in das Substrat 16 eingebracht.

Es ist zu erkennen, dass sich die Kalibrierstruktur 12 entlang einer Erstreckungsrichtung E erstreckt, wohingegen sich die Nutzstruktur 14 in eine Vorzugsrichtung V erstreckt. Zwischen der Erstreckungsrichtung E und der Vorzugsrichtung V ist ein Azimutalwinkel $\varphi$ gebildet, der im vorliegenden Fall 0,25° beträgt.

Figur 1b zeigt eine Schnittansicht entlang des Schnittes A-A. Es ist zu erkennen, dass sich die Oberseiten der Stege 20.i entlang einer Kalibrierstruktur-Ebene K erstrecken. Die in Figur 1b nicht eingezeichnete Nutzstruktur erstreckt sich entlang einer Nutzstruktur-Ebene N, die der Kalibrierstruktur-Ebene K entspricht oder parallel zu dieser verläuft.

Die Nut-Breite $B_{18}$ ist vorzugsweise im Wesentlichen so groß wie ein Abstand zweier benachbarter länglicher Strukturen der Nutzstruktur 14. Darunter ist zu verstehen, dass die Nut-Breite $B_{18}$ um höchstens 30% von einem Zwischenraum zwischen zwei benachbarten Strukturen der Nutzstruktur 14 abweicht. Günstig ist es zudem, wenn - wie im vorliegenden Fall - die Stegbreite $B_{20}$ höchstens 20% von einer Breite eines Stegs der Nutzstruktur 14 abweicht.

Die Nuten 18.i können auch als Gräben bezeichnet werden. Wie die Figuren 1a und 1b zeigen, sind die Nuten 18.i periodisch und im vorliegenden Fall äquidistant angeordnet. Eine Strukturbreite p beträgt folglich $p_{12}$ = $B_{20}$ + $B_{18}$.

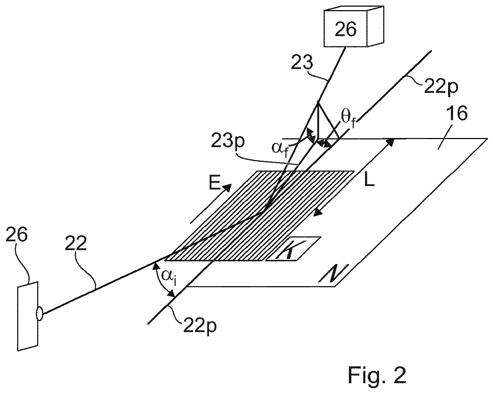

Figur 2 zeigt schematisch den Versuchsaufbau zum Vermessen der Kalibrierstruktur 12 mittels eines Strahls 22 aus einer Strahlquelle 24. Im vorliegenden Fall ist die Strahlquelle 24 eine Röntgenröhre in Form einer Drehanoden-Röntgenröhre. Alternativ können als Strahlungsquelle beispielsweise freie Elektronen-Laser, Synchrotron-Strahlungsquellen, Röntgenröhren mit Flüssigmetallstrahl-Anode oder Strahlungsquellen gewählt werden, die die Strahlung per Laserinduziertem Plasma erzeugen.

Es ist des Weiteren möglich, dass die Strahlungsquelle eine DPP-Quelle ist (englisch: discharge-produced plasma). Wiederum alternativ ist die Strahlungsquelle 24 ein HHG-Generator (HHG, englisch: high harmonic generation, Röntgenstrahlerzeugung durch hohe Harmonische). Eine Wellenlänge $\lambda$ der von der Strahlungsquelle 24 ausgesandten Strahlung liegt vorzugsweise im Bereich zwischen 20 Nanometer und 0,04 Nanometer.

Figur 2 zeigt zudem, dass der Strahl 22 monochromatischer Strahlung unter einem Einfallswinkel $\alpha_i$ auf die Kalibrierstruktur-Ebene K trifft. Der Einfallswinkel $\alpha_i$ wird zwischen dem Strahl 22 und der Nutzstruktur-Ebene gemessen und ist vorzugsweise größer als 1° und kleiner als 7°.

Figur 2 zeigt zudem, dass die Projektion 22p des einfallenden Strahls 22 auf die Kalibrierstruktur-Ebene K parallel zur Erstreckungsrichtung E verläuft, entlang der die Stege 20.i und damit die Nuten 18.i verlaufen.

Eingezeichnet ist zudem ein reflektierter Strahl 23 und die Projektion $23_p$ auf die Nutzstruktur-Ebene N. Zwischen der Nutzstruktur-Ebene N und der reflektierten Strahlen 23 besteht der Höhen-Ausfallwinkel $\alpha_f$. Zwischen der Verlängerung der Projektion 22p des einfallenden Strahls einerseits und der Projektion 23p des reflektierenden Strahls 23 andererseits existiert der Ebenen-Ausfallwinkel $\theta_f$.

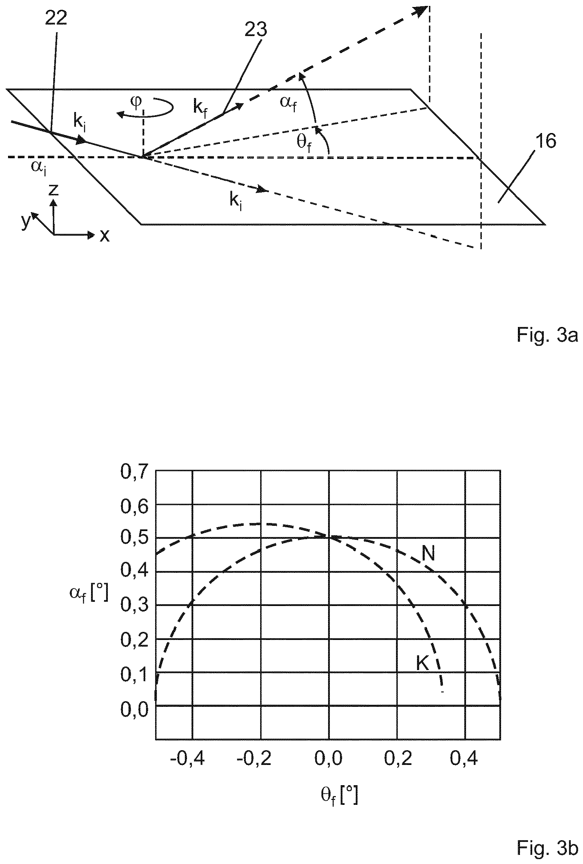

Figur 3a zeigt den Versuchsaufbau gemäß Figur 2 in einer anderen Ansicht.

Figur 3b zeigt die berechneten Ewald-Kreise für die Nutzstruktur und die Kalibrierstruktur, die im vorliegenden Fall beide als Gitter simuliert sind.

Das erfindungsgemäße Verfahren wird vorzugsweise bei Vakuum-Wellenlängen von zumindest $\lambda$ = 0,04 Nanometer durchgeführt. Es wird vorzugsweise bei Vakuum-Wellenlängen bis 20 Nanometer durchgeführt, beispielsweise im EUV-Bereich von 1 Nanometer bis 20 Nanometer durchgeführt. Die Strukturbreite p beträgt vorzugsweise zwischen 10 Nanometer und 15 Nanometer. Die folgende Tabelle zeigt exemplarisch mögliche Messparameter auf. Angenommen wird eine Winkelauflösung einer Winkelmessapparatur, mittels der der Höhen-Ausfallswinkel $\alpha_f$ und der Ebenen-Ausfallwinkel $\theta_f$ gemessen werden.

| Wellenlänge $\lambda$/nm | Winkelauflösung/° | Einfallswinkel $\alpha_i$/° | Beugungsordnung n | Pitch p/nm | Drehung φ der Kalibrierstruktur/° |
|---|---|---|---|---|---|
| 0,04 | 0,04 | 0,2 | 9 | 50 | > 0,2 |
| 0,1 | 0,04 | 0,5 | 9 | 50 | > 0,2 |
| 1 | 0,04 | 5 | 9 | 50 | > 0,2 |
| 5 | 0,04 | 30 | 9 | 50 | > 0,25 |
| 20 | 0,04 | 60 | 4 | 50 | > 0,1 |

| Wellenlänge $\lambda$/nm | Winkelauflösung/° | Einfallswinkel $\alpha_i$/° | Beugungsordnung n | Pitch p/nm | Drehung φ der Kalibrierstruktur/° |
|---|---|---|---|---|---|
| 0,04 | 0,04 | 1,0 | 9 | 10 | >0,2 |
| 0,1 | 0,04 | 2,5 | 9 | 10 | >0,2 |
| 1 | 0,04 | 25 | 9 | 10 | >0,2 |

Das Vermessen der Kalibrierstruktur 12 erfolgt in Reflexionsanordnung, das heißt, dass ein Detektor 26 auf der gleichen Seite der Kalibrierstruktur-Ebene K angeordnet ist wie die Strahlquelle 24. Der Detektor 26 zeichnet lediglich die Strahlung auf, die von der Kalibrierstruktur 12 reflektiert wurde. Die Strahlung, die von der Nutzstruktur 14 reflektiert wurde, wird am Detektor 26 vorbei reflektiert.

**Bezugszeichenliste**

10   Belichtungsmaske
12   Kalibrierstruktur
14   Nutzstruktur
16   Substrat
18   Nut

20   Steg
22   einfallender Strahl
23   reflektierender Strahl
24   Strahlquelle/Röntgenröhre
26   Detektor

$B_{18}$   Nut-Breite
$B_{20}$   Steg-Breite
E   Erstreckungsrichtung
i   Zählindex

K   Kalibrierstruktur-Ebene
N   Nutzstruktur-Ebene
T   Tiefe
V   Vorzugsrichtung

$\alpha_i$   Einfallswinkel
$\varphi$   Azimutalwinkel

λ    Wellenlänge
$\alpha_f$    Höhen-Ausfallswinkel
$\theta_f$    Ebenen-Ausfallwinkel
n    Beugungsordnung
p    Strukturbreite

**Patentansprüche**

1. Verfahren zur Qualitätssicherung einer mikroelektronischen Nutzstruktur (14) mit den Schritten:

   (a) Aufbringen einer Kalibrierstruktur (12) und der Nutzstruktur (14) auf ein Substrat (10),
   wobei die Nutzstruktur (14) eine Vorzugsrichtung (V) aufweist und
   wobei sich die Kalibrierstruktur (12) in eine Erstreckungsrichtung (E) erstreckt und periodisch aufgebaut ist,
   (b) Vermessen der Kalibrierstruktur (12) mittels monochromatischer Strahlung und
   (c) Bestimmen einer Abweichung der Kalibrierstruktur (12) von einer Soll-Kalibrierstruktur,
   **dadurch gekennzeichnet, dass**
   (d) die Erstreckungsrichtung (E) einen Azimutalwinkel (φ) mit der Vorzugsrichtung (V) bildet, sodass beim Vermessen der Kalibrierstruktur (12) in einer Beugungsordnung (n), die von null verschieden ist, Reflexionsstrahlungsanteile von der Nutzstruktur (14) und von der Kalibrierstruktur (12) separiert sind.

2. Verfahren nach Anspruch 1, **dadurch gekennzeichnet, dass**
   das Vermessen der Kalibrierstruktur (12) in Reflexionsanordnung und in einer Beugungsordnung (n) erfolgt, die zumindest 4 beträgt.

3. Verfahren nach einem der vorstehenden Ansprüche, **dadurch gekennzeichnet, dass** der Azimutalwinkel (φ)

   - zumindest 0,1° beträgt und/oder
   - höchstens 20° beträgt.

4. Verfahren nach einem der vorstehenden Ansprüche, **dadurch gekennzeichnet, dass**

   - eine Strukturbreite ($p_{12}$) der Kalibrierstruktur (12) und/oder
   - eine Strukturbreite ($p_{14}$) der Nutzstruktur (14)

   höchstens 60 Nanometer beträgt.

5. Verfahren nach einem der vorstehenden Ansprüche, **dadurch gekennzeichnet, dass** die monochromatische Strahlung eine Vakuum-Wellenlänge (λ) von höchstens 20 Nanometer und/oder zumindest 0,04 Nanometer hat.

6. Verfahren nach einem der vorstehenden Ansprüche, **dadurch gekennzeichnet, dass**

   - ein Einfallswinkel ($\alpha_i$), unter dem die monochromatische Strahlung auf die Kalibrierstruktur (12) fällt,
   - die Beugungsordnung (n), in der die reflektierte Strahlung gemessen wird,
   - die Vakuum-Wellenlänge (λ) der monochromatischen Strahlung und
   - der Azimutalwinkel (φ)

   so gewählt werden, dass

   (a) für eine azimutalwinkelbedingte Höhen-Ausfallswinkeldifferenz ($\Delta\alpha_f$) gilt:

$$\Delta\alpha_f = \left|\alpha_{f,12} - \alpha_{f,14}\right| = \left|\arcsin\left(\sqrt{\sin^2\alpha_i - \left(\frac{n\lambda}{p_{12}}\right)^2} - \sin\varphi\cos\alpha_i\frac{n\lambda}{p_{12}}\right) - \right.$$

$$\left. \arcsin\left(\sqrt{\sin^2\alpha_i - \left(\frac{n\lambda}{p_{14}}\right)^2}\right)\right| \geq 0{,}05°,$$

wobei $p_{12}$ die Strukturbreite der Kalibrierstruktur (12) ist und
wobei $p_{14}$ eine Strukturbreite der Nutzstruktur (14) ist und/oder dass
(b) für eine azimutalwinkelbedingte Ebenen-Ausfallswinkeldifferenz $\Delta\theta_f$ gilt:

$$\Delta\theta_f = \left|\theta_{f,12} - \theta_{f,14}\right| = \left|\arcsin\left(\frac{n\lambda}{p_{12}}\frac{\cos\varphi}{\cos\alpha_f}\right) - \arcsin\left(\frac{n\lambda}{p_{14}}\frac{1}{\cos\alpha_f}\right)\right| \geq 0{,}05°.$$

7. Verfahren nach einem der vorstehenden Ansprüche, **dadurch gekennzeichnet, dass** das Vermessen der Kalibrierstruktur (12) an einem Wafer zwischen zwei Lithographie-Schritten erfolgt, während denen jeweils zumindest eine Schicht strukturiert wird.

8. Verfahren nach einem der vorstehenden Ansprüche, **dadurch gekennzeichnet, dass** zum Belichten eine Belichtungsmaske (10) mit

(a) einer Kalibrierstruktur (12),

- die sich in eine Erstreckungsrichtung (E) erstreckt und
- die periodisch aufgebaut ist und
- eine Strukturbreite ($p_{12}$) hat,

(b) wobei die Nutzstruktur (14) sich in eine Vorzugsrichtung (V) erstreckt und
(c) wobei die Erstreckungsrichtung (E) einen Azimutalwinkel ($\varphi$) mit der Vorzugsrichtung (V) bildet, sodass beim Vermessen der Kalibrierstruktur (12) in einer Beugungsordnung (n), die von null verschieden ist, Reflexionsstrahlungsanteile von der Nutzstruktur (14) und von der Kalibrierstruktur (12) separierbar sind,

eingesetzt wird.

9. Substrat mit einer mikroelektronischen Nutzstruktur (14), mit

(a) einer Kalibrierstruktur (12),

- die sich in eine Erstreckungsrichtung (E) erstreckt und
- die periodisch aufgebaut ist und
- eine Strukturbreite ($p_{12}$) hat,

(b) wobei die Nutzstruktur (14) sich in eine Vorzugsrichtung (V) erstreckt,
**dadurch gekennzeichnet, dass**
(c) die Erstreckungsrichtung (E) einen Azimutalwinkel ($\varphi$) mit der Vorzugsrichtung (V) bildet, sodass beim Vermessen der Kalibrierstruktur (12) in einer Beugungsordnung (n), die von null verschieden ist, Reflexionsstrahlungsanteile von der Nutzstruktur (14) und von der Kalibrierstruktur (12) separierbar sind.

10. Substrat nach Anspruch 9 in Form einer Belichtungsmaske zur Herstellung von Halbleiter-Bauelementen oder Wafer, **dadurch gekennzeichnet, dass**
der Azimutalwinkel ($\varphi$)

- zumindest 0,1° beträgt und/oder
- höchstens 45° beträgt.

11. Belichtungsmaske nach Anspruch 9 oder 10, **dadurch gekennzeichnet, dass**
eine Strukturbreite ($p_{12}$) der Kalibrierstruktur (12) und/oder eine Strukturbreite ($p_{14}$) der Nutzstruktur (14) höchstens 15 Nanometer beträgt.

Fig. 1a

A - A

Fig. 1b

Fig. 2

Fig. 3a

Fig. 3b

**Europäisches Patentamt**
**European Patent Office**
**Office européen des brevets**

# EUROPÄISCHER RECHERCHENBERICHT

**Nummer der Anmeldung**

EP 17 20 7075

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2010/025950 A1 (ASML NETHERLANDS BV [NL]; SMILDE HENDRIK [NL]; COENE WILLEM [NL]) 11. März 2010 (2010-03-11) * Absatz [0004] - Absatz [0059] * * Abbildungen 1,4,6 * ----- | 1-11 | INV. G03F7/20 G02B27/44 G01B11/24 G03F1/38 G03F1/44 |
| A | US 2013/215404 A1 (DEN BOEF ARIE JEFFREY [NL]) 22. August 2013 (2013-08-22) * das ganze Dokument * ----- | 1,9 | G02B5/18 G03F9/00 H01L21/266 |

**RECHERCHIERTE SACHGEBIETE (IPC)**

G03F

Der vorliegende Recherchenbericht wurde für alle Patentansprüche erstellt

| Recherchenort | Abschlußdatum der Recherche | Prüfer |
|---|---|---|
| München | 27. April 2018 | Meixner, Matthias |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.......................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 17 20 7075

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-04-2018

| Im Recherchenbericht angeführtes Patentdokument | Datum der Veröffentlichung | Mitglied(er) der Patentfamilie | Datum der Veröffentlichung |
|---|---|---|---|
| WO 2010025950 A1 | 11-03-2010 | NL 2003388 A | 15-03-2010 |
| | | US 2011194092 A1 | 11-08-2011 |
| | | WO 2010025950 A1 | 11-03-2010 |
| US 2013215404 A1 | 22-08-2013 | CN 104220932 A | 17-12-2014 |
| | | CN 105549341 A | 04-05-2016 |
| | | JP 6033890 B2 | 30-11-2016 |
| | | JP 2015510126 A | 02-04-2015 |
| | | JP 2017026638 A | 02-02-2017 |
| | | KR 20140135998 A | 27-11-2014 |
| | | KR 20170016526 A | 13-02-2017 |
| | | NL 2010211 A | 26-08-2013 |
| | | US 2013215404 A1 | 22-08-2013 |
| | | US 2015346609 A1 | 03-12-2015 |
| | | WO 2013124131 A2 | 29-08-2013 |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **SOLTWISCH et al.** Determination of line profiles on nano-structured surfaces using EUV and X-ray scattering. *Proceedings of SPIE, Vol. 9235, 2014 Photomask Technology,* 2014, vol. 9235, 92351D-1, 92351D-9
- **MARLOWE et al.** Modeling and empirical characterization of the polarization response of offplane reflection grating. *Applied optics,* vol. 55 (21), 5548-5553
- **SOLTWISCH et al.** Determination of line profiles on nano-structured surfaces using EUV and X-ray scattering. *Proc. of SPIE,* vol. 9235
- **SUH et al.** Characterization of the shape and line-edge roughness of polymer grating with grazing incidence small-angle X-ray scattering and atomic force microscopy. *J. Appl. Chryst.,* 2016, vol. 49
- **WERNECKE et al.** Direct structural characterization of line gratings with grazing incidence small-angle x-ray scattering. *REVIEW OF SCIENTIFIC INSTRUMENTS,* 2012, vol. 83, 102906